**Europäisches Patentamt**

**European Patent Office**

**Office européen des brevets**

(19)

(11) Veröffentlichungsnummer: **0 105 437**
**A2**

(12) **EUROPÄISCHE PATENTANMELDUNG**

(21) Anmeldenummer: 83109560.9

(22) Anmeldetag: 26.09.83

(51) Int. Cl.³: **G 01 R 11/00**
**G 01 R 11/44**

(30) Priorität: 30.09.82 DE 3236316

(43) Veröffentlichungstag der Anmeldung:
18.04.84 Patentblatt 84/16

(84) Benannte Vertragsstaaten:
AT CH DE FR GB IT LI

(71) Anmelder: SIEMENS AKTIENGESELLSCHAFT
Berlin und München Wittelsbacherplatz 2
D-8000 München 2(DE)

(72) Erfinder: Göttler, Ernst, Dr.
Otto-Engl-Platz 7
D-8000 München 60(DE)

(72) Erfinder: Oefele, Karl, Dipl.-Phys.
Boschetsriederstrasse 132
D-8000 München 70(DE)

(54) Einrichtung zum Messen des Verbrauchs elektrischer Energie in einem Stromkreis, der aus einer eine bestimmte, praktisch gleichbleibende Spannung ausweisenden Stromquelle mit Strom versorgt wird.

(57) In dem Stromkreis, in dem der Verbrauch elektrischer Energie zu messen ist, ist ein eingangsseitig eingefügter Stromwandler vorgesehen, dessen Ausgang eine dem eingangsseitig fließenden Strom proportionale Spannung erzeugt. An den Ausgang des Stromwandlers ist ein elektrolytischer Betriebsstundenzähler angeschlossen, der eine Anzeige entsprechend dem Produkt aus Strom und Zeit liefert. Da die Verbraucherspannung bekannt ist, kann die Anzeige, die vorzugsweise in kWh geeicht ist, die verbrauchte elektrische Arbeit anzeigen.

0105437

SIEMENS AKTIENGESELLSCHAFT
Berlin und München

Unser Zeichen
VPA 82 P 1 9 2 3 E

Einrichtung zum Messen des Verbrauchs elektrischer Energie in einem Stromkreis, der aus einer eine bestimmte,
praktisch gleichbleibende Spannung aufweisenden Stromquelle mit Strom versorgt wird

Die Energiekrise hat dazu geführt, daß die Verbraucher
auch durch zuständige amtliche Stellen zur Verringerung
des Energiebedarfs, beispielsweise für die Gebäudeheizung, angehalten werden. Ein Energiesparen wird vom Verbraucher allerdings im allgemeinen nur dann für sinnvoll
gehalten, wenn dieser seinen persönlichen Energieverbrauch
kennt. Zu diesem Zweck wurde vom Bundesministerium für
Wirtschaft die Heizkostenverordnung vom 23.2.1981 erlassen. Darin ist festgelegt, daß für vermietete Räume Vorrichtungen vorzusehen sind, die die Messung der in diesen Räumen verbrauchten Heizenergie gestatten.

Die im folgenden beschriebene Erfindung betrifft insbesondere Elektroheizungen (Nachtstromspeicher, Heißwasserspeicher, Heizlüfter, Radiatoren u. a.).

Prinzipiell könnte die gewünschte Verbrauchsmessung dadurch ermöglicht werden, daß die Stromkreise der Räume
eines Mieters oder zumindest die betreffenden Heizstromkreise zusammengefaßt und über einen zusätzlichen Zähler
herkömmlicher Bauart geführt werden. Dies ist aber sehr
aufwendig und als nachträgliche Maßnahme in den meisten
Fällen nicht oder zumindest nur schwer durchführbar. Deshalb ist in der oben genannten Verordnung auch eine Ausnahme für den Fall vorgesehen, daß die Durchführung der
erforderlichen Maßnahmen einen unverhältnismäßig großen
Aufwand bedeutet.

Pap 1 Wi/28.09.1982 Der vorliegenden Erfindung liegt die Aufgabe zugrunde, eine Einrichtung zum Messen des Verbrauchs elektrischer Energie der eingangs genannten Art zu schaffen, die einen verhältnismäßig einfachen, raumsparenden Aufbau hat, kostengünstig herzustellen ist sowie zeitsparend und somit auch kostengünstig in bestehenden Anlagen nachträglich zu installieren ist.

Die der Erfindung zugrundeliegende Aufgabe wird durch eine Einrichtung zum Messen des Verbrauchs elektrischer Energie in einem Stromkreis, der aus einer eine bestimmte, praktisch gleichbleibende Spannung aufweisenden Stromquelle mit Strom versorgt wird, gelöst, die dadurch gekennzeichnet ist, daß in den Stromkreis, in dem der Verbrauch elektrischer Energie zu messen ist, ein eingangsseitig eingefügter Stromwandler vorgesehen ist, dessen Ausgang eine dem eingangsseitig fließenden Strom proportionale Spannung erzeugt, daß an den Ausgang des Stromwandlers ein Betriebsstundenzähler angeschlossen ist, der eine Anzeige entsprechend dem Produkt aus Strom und Zeit liefert, und daß die Anzeige aufgrund der Tatsache, daß die Spannung der Stromquelle für den Verbraucherstromkreis konstant ist oder um einen bestimmten Mittelwert schwankt, in einer Angabe für das Produkt aus Leistung und Zeit, z. B. in kWh, geeicht ist.

Vorteilhafte Weiterbildungen sind durch die in den Unteransprüchen angegebenen Merkmale gekennzeichnet.

Die Verbrauchsmeßeinrichtung oder der Zähler enthält ein Bauteil, das in letzter Zeit auf den Markt gekommen ist. Es handelt sich um einen elektrolytischen Betriebsstundenzähler. Er hat die Form einer Feinsicherung und kostet im Einzelhandel ca. DM 10,- (Lieferquelle: Fuji Ceramics, Bezug über Nucletron, München). Im Sinne des Herstellers wird das Bauteil mit Vorwiderstand so beschaltet, daß es bei konstanter Spannung die Zahl der Betriebsstunden anzeigt (Roter Punkt auf einer Skala von 1 bis 10).

Im folgenden wird die Erfindung anhand einer Figur erläutert.

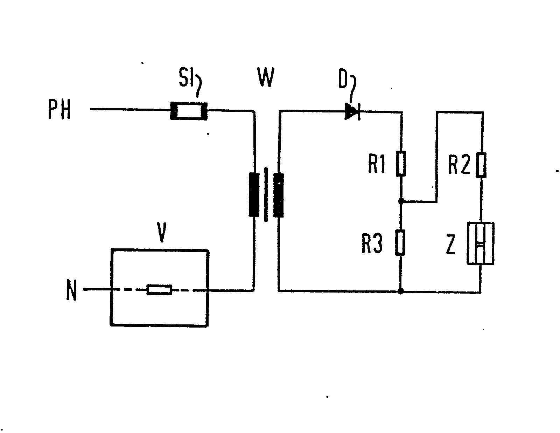

Die Figur zeigt ein Prinzipschaltbild für einen Eingangskreis mit einem über eine Sicherung SI und einen als
Transformator ausgeführten Stromwandler W über dessen
Primärwicklung zwischen den Phasenleiter PH und den Nullleiter N eines Stromversorgungsnetzes gelegten Verbraucher
V sowie für einen Ausgangskreis mit einer Diode D, Widerständen R1, R2, R3 und einem Betriebsstundenzähler Z, wobei
die Widerstände R1 und R3 einen Spannungsteiler bilden,
an dessen Abgriff der Widerstand R2 als Vorwiderstand angeschlossen ist, dessen anderer Anschlußpunkt an einen
Anschlußpunkt des Betriebsstundenzählers Z geführt ist.
Der andere Anschlußpunkt des Betriebsstundenzählers Z ist
mit dem einen Ende des Spannungsteilers, nämlich mit dem
äußeren Anschlußpunkt des Widerstandes R3, und einem Wikklungsende der Sekundärwicklung des Stromwandlers W verbunden. Das Prinzip der Stromwandlung mittels eines Transformators ist an sich aus der Meßtechnik bekannt.

Die in der Figur dargestellte Schaltungsanordnung stellt
nur ein bevorzugtes Ausführungsbeispiel dar. Selbstverständlich sind andere Ausgestaltungen der Erfindung realisierbar, die - was das Stromwandlungsprinzip betrifft -
für den Fachmann naheliegen.

Mit der in der Figur angegebenen Beschaltung ist es möglich, das Produkt aus Strom und Zeit zu messen. Da die
Spannung über dem Verbraucher bekannt und konstant ist,
kann die Skala vorzugsweise in kWh geeicht werden. Die
Schaltung kann etwa in der Bauform eines Sicherungsautomaten aufgebaut und beispielsweise neben der Sicherung
des zu messenden Stromkreises in die Verteilung eingebaut werden.

Da nach der eingangs genannten Verordnung nur ein Grundanteil von 50% - 70% der Heizenergie individuell, der
Rest hingegen pauschal abzurechnen ist, ist die Genauigkeit des beschriebenen Zählers auf alle Fälle ausreichend. Die Ablesung (1 x pro Jahr) wird vom Vermieter
oder dessen Beauftragten im Beisein des Mieters vorgenommen. Dabei ist es zweckmäßig, den elektrolytischen
Zähler wie eine Feinsicherung aus seiner Halterung zu
nehmen und gegen einen auf Null stehenden auszutauschen.
Die gebrauchten Zähler können in einfacher Weise durch
Umpolen in einem Regeneriergerät wieder auf Null gestellt
werden.

Der Anzeigebereich des Zählers ist beispielsweise bei
einem 10kWh-Verbraucher (d. h. ca. 15A pro Phase) mit
3300h - ca. 4.5 Monate bei Dauerbetrieb anzusetzen. Da
die durchschnittliche Einschaltdauer im allgemeinen wesentlich kleiner ist (8h pro Tag während der Heizperiode),
ergibt sich ein Anzeigebereich 1 Jahr.

Für die Anzeige des Verbrauchs bei größeren Strömen muß
der Eisenquerschnitt des Transformators entsprechend gewählt werden. Der Anzeigebereich wird mit den Widerständen R1 und R3 eingestellt. Somit es es - ausgehend von
einem Gerätetyp für einen maximalen Strom - möglich,
einen Standardtransformator zu verwenden.

7 Patentansprüche
1 Figur

Patentansprüche:

1. Einrichtung zum Messen des Verbrauchs elektrischer Energie in einem Stromkreis, der aus einer eine bestimmte, praktisch gleichbleibende Spannung aufweisenden Stromquelle mit Strom versorgt wird, d a d u r c h g e - k e n n z e i c h n e t , daß in den Stromkreis, in dem der Verbrauch elektrischer Energie zu messen ist, ein eingangsseitig eingefügter Stromwandler vorgesehen ist, dessen Ausgang eine dem eingangsseitig fließenden Strom proportionale Spannung erzeugt, daß an den Ausgang des Stromwandlers ein Betriebsstundenzähler (Z) angeschlossen ist, der eine Anzeige entsprechend dem Produkt aus Strom und Zeit liefert, und daß die Anzeige aufgrund der Tatsache, daß die Spannung der Stromquelle für den Verbraucherstromkreis konstant ist oder um einen bestimmten Mittelwert schwankt, in einer Angabe für das Produkt aus Leistung und Zeit, z. B. in kWh, geeicht ist.

2. Einrichtung nach Anspruch 1, d a d u r c h g e - k e n n z e i c h n e t , daß der Stromverbraucher (W) als Transformator ausgeführt ist, wenn die Stromquelle (PH/N) eine Wechselstromquelle ist.

3. Einrichtung nach Anspruch 2, d a d u r c h g e - k e n n z e i c h n e t , daß der Betriebsstundenzähler (Z) an den Ausgang des Stromwandlers (W) mittelbar oder unmittelbar über einen Gleichrichter angeschlossen ist.

4. Einrichtung nach einem der vorhergehenden Ansprüche, d a d u r c h g e k e n n z e i c h n e t , daß der Betriebsstundenzähler (Z) mit einem seiner Anschlüsse direkt an einen Anschlußpunkt des Ausgangs des Stromwandlers (W) und mit seinem anderen Ende an den Verbindungspunkt eines aus zumindest zwei Widerständen (R1, R3) bestehenden Spannungsteilers, der die am Ausgang des Stromwandlers (W) entstehende Spannung teilt, angeschlossen
ist.

5. Einrichtung nach Anspruch 4, d a d u r c h  g e -
k e n n z e i c h n e t ,  daß der Betriebsstundenzähler (Z) über einen Vorwiderstand (R2) an den Verbindungspunkt des Spannungsteilers (R1/R2) angeschlossen
ist.

6. Einrichtung nach einem der vorhergehenden Ansprüche,
d a d u r c h  g e k e n n z e i c h n e t ,  daß der
Betriebsstundenzähler (Z) ein elektrolytischer Betriebsstundenzähler ist.

7. Einrichtung nach einem der vorhergehenden Ansprüche,
d a d u r c h  g e k e n n z e i c h n e t ,  daß
eine Konstruktion vorgesehen ist, gemäß derer die Elemente, nämlich der Stromwandler (W), der Betriebsstundenzähler (Z) sowie ggf. vorgesehene Hilfsbauelemente, wie
Gleichrichter, Widerstände usf., in einem gemeinsamen
Gehäuse untergebracht sind, das vorzugsweise die Bauform eines herkömmlichen Sicherungsautomaten hat.